(19) Europäisches Patentamt / European Patent Office / Office européen des brevets

(11) **EP 3 058 584 B1**

(12) **FASCICULE DE BREVET EUROPEEN**

(45) Date de publication et mention de la délivrance du brevet:
**04.11.2020 Bulletin 2020/45**

(21) Numéro de dépôt: **14786174.4**

(22) Date de dépôt: **16.10.2014**

(51) Int Cl.:
**B82B 3/00** *(2006.01)*     *H01L 21/302* *(2006.01)*
**H01L 21/3105** *(2006.01)*

(86) Numéro de dépôt international:
**PCT/EP2014/072259**

(87) Numéro de publication internationale:
**WO 2015/055783 (23.04.2015 Gazette 2015/16)**

(54) **PROCÉDÉ DE FABRICATION D'OBJETS NANOMÉTRIQUES EXPLOITANT LA RUPTURE D'UNE COUCHE DÉFORMÉE PAR DES RIDES**

VERFAHREN ZUR HERSTELLUNG NANOMETRISCHER OBJEKTE MITHILFE DES BRUCHES EINER DURCH FALTEN VERFORMTEN SCHICHT

METHOD FOR MANUFACTURING NANOMETRIC OBJECTS USING THE RUPTURE OF A LAYER DEFORMED BY WRINKLES

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **17.10.2013 FR 1360110**

(43) Date de publication de la demande:
**24.08.2016 Bulletin 2016/34**

(73) Titulaire: **Commissariat à l'Énergie Atomique et aux Énergies Alternatives
75015 Paris (FR)**

(72) Inventeurs:
• **BENAISSA, Lamine
  F-91300 Massy (FR)**
• **MOULET, Jean-Sébastien
  F-73000 Chambéry (FR)**

(74) Mandataire: **Brevalex
95, rue d'Amsterdam
75378 Paris Cedex 8 (FR)**

(56) Documents cités:
• **"New ripple patterns observed in excimer-laser irradiated SiO2/polycrystalline silicon/SiO2 structures", APPLIED PHYSICS LETTERS, AMERICAN INSTITUTE OF PHYSICS, US, vol. 70, no. 26, 30 juin 1997 (1997-06-30) , page 3552, XP012018143, ISSN: 0003-6951, DOI: 10.1063/1.119230**
• **URYI P. VOLKOV ET AL: "Microscopy of Si and Ge nanospherical particles", PROCEEDINGS OF SPIE, 14 juillet 2004 (2004-07-14), pages 21-25, XP055157916, ISSN: 0277-786X, DOI: 10.1117/12.568563**

## Description

## DOMAINE TECHNIQUE

Le domaine de l'invention est celui de la fabrication d'objets de taille nanométrique susceptibles de trouver application par exemple en optique ou en micro(nano)-électronique.

L'invention concerne plus précisément un procédé de fabrication de d'objets nanométriques, ce procédé reposant sur la formation d'ondulations en surface d'un substrat, ces ondulations étant communément désignées par le terme de rides et caractérisées par une amplitude, une longueur d'onde et une orientation. Un exemple de tels objets est celui de billes pouvant servir en tant que germe pour la croissance cristalline de nanofils.

## ÉTAT DE LA TECHNIQUE ANTÉRIEURE

Les objets nanométriques peuvent être synthétisés selon une approche ascendante (*bottom-up*) ou descendante (*top-down*). L'approche ascendante consiste à fabriquer ces objets un atome ou une molécule à la fois à l'aide de procédés tels que la synthèse chimique, l'auto-assemblage ou l'assemblage par positionnement individuel. L'approche descendante consiste à prendre une substance de grand format et de la modifier pour atteindre des dimensions nanométriques. La gravure à l'eau forte, l'ingénierie de précision, la lithographie et le broyage sont des approches courantes. Plusieurs de ces techniques sont couramment utilisées en salle blanche dans l'industrie électronique. Les deux approches, ascendante et descendante, tendent à converger en termes de dimension des particules synthétisées.

On connait de l'article « New ripple patterns observed in excimer-laser irradiated SiO2/polycrystalline silicon/SiO2 structures » de G.K. Giust et T.W. Sigmon (Appl. Phys. Lett. 70, 3552, 1997) une technique qui consiste à venir fusionner une couche de polysilicium recouverte d'une couche d'oxyde au moyen d'une irradiation laser, cette fusion résultant en la formation de rides.

L'article "Microscopy of Si and Ge nanospherical particles" de Uryi P. Volkov (Proceedings of the SPIE, 14 juillet 2004, pages 21-25) divulgue un procédé de fabrication de particules nanosphériques.

## EXPOSÉ DE L'INVENTION

Dans ce cadre, l'invention vise une approche originale pour une synthèse d'objets nanométriques peu complexe et aisément reproductible.

L'invention propose à cet effet un procédé de fabrication d'un objet nanométrique à partir d'une structure comprenant une couche élastique contrainte sur une fondation à l'état solide présente en surface d'un substrat rigide, le procédé comprenant les étapes de :

- fusion de la fondation pour l'amener à l'état liquide pendant une durée supérieure ou égale à 50 ns, l'épaisseur de la fondation étant d'au moins 20 nm et inférieure à une épaisseur prédéterminée correspondant à une amplitude crête à crête théorique de rides, ladite fusion résultant en une relaxation de contrainte de la couche élastique qui engendre une déformation simultanée, par formation de rides, de la couche élastique et de la fondation, la formation des rides s'accompagnant d'un contact localisé entre la couche élastique et le substrat rigide isolant des régions de la fondation ;
- solidification de la fondation pour la ramener à l'état solide, ladite solidification formant une structure solide présentant des rides en surface ;

le procédé étant caractérisé en ce que les étapes de fusion et de solidification sont réitérées pour augmenter l'intervalle entre les régions isolées de la fondation jusqu'à atteindre la limite de rupture de la couche élastique.

La rupture de la couche élastique s'accompagne d'une éruption du liquide en fusion issu de la fondation, formant ainsi un objet de taille nanométrique, par exemple une bille. L'invention utilise ainsi avantageusement une technique de structuration de surface par formation de rides pour permettre la fabrication d'objets nanométriques.

Certains aspects préférés mais non limitatifs de ce procédé sont les suivants :

- la fusion est réalisée au moyen d'un apport d'énergie sélectif selon lequel l'énergie est absorbée par la fondation plutôt que par la couche élastique contrainte avec un ratio de 100/1, de préférence avec un ratio de 1000/1 ;
- la durée de chacune des étapes de fusion et de solidification est inférieure à 1 seconde, de préférence inférieure à 1 microseconde ;
- une couche thermiquement isolante peut être intercalée entre la fondation et le substrat rigide ;
- la couche élastique dispose initialement d'une contrainte présentant une rupture de continuité dans le plan de la couche.

## BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :

- les figures la-lc illustrent la structuration de surface par formation de rides ;
- les figures 2a-2d illustrent un exemple de procédé de formation de rides ;
- la figure 3 représente des rides formées en surface d'un substrat par mise en œuvre du procédé de formation de rides des figures 2a-2d ;

- les figures 4a-4c illustrent un cycle fusion/solidification mis en œuvre dans le procédé selon l'invention ;

- les figures 5a-5b illustrent la création d'un bas-relief pour orienter les rides formées en surface d'un substrat dans une mise en œuvre du procédé selon de l'invention ;

- les figures 6a-6e illustrent le procédé selon l'invention ;

- la figure 7 représente les rides formées en surface d'un substrat selon le nombre de réitérations des étapes de fusion et de solidification du procédé selon l'invention ;

- la figure 8 illustre l'éruption de billes nanométriques lors de la rupture de la couche élastique ;

- la figure 9 est une vue en coupe d'une structure obtenue par une mise en œuvre du procédé selon l'invention conduisant à l'éruption de billes nanométriques.

## EXPOSÉ DÉTAILLÉ DE MODES DE RÉALISATION PARTICULIERS

L'invention repose sur l'idée originale d'utiliser un procédé de structuration de surface afin de le détourner pour conduire à la formation d'objets nanométriques, tels que des billes nanométriques.

La structuration de surface trouve application dans de nombreux domaines, tels que dans le domaine de l'électronique où elle permet notamment la miniaturisation des composants, ou encore dans le domaine de l'optique où elle permet par exemple d'améliorer l'efficacité de la collection de lumière de cellules photovoltaïques.

Si la structuration de surface est généralement réalisée par lithographie, les approches non lithographiques basées sur des processus thermodynamiques d'auto-organisation apparaissent particulièrement attractives compte tenu de leur potentiel économique et de leur compatibilité avec la production à grande échelle.

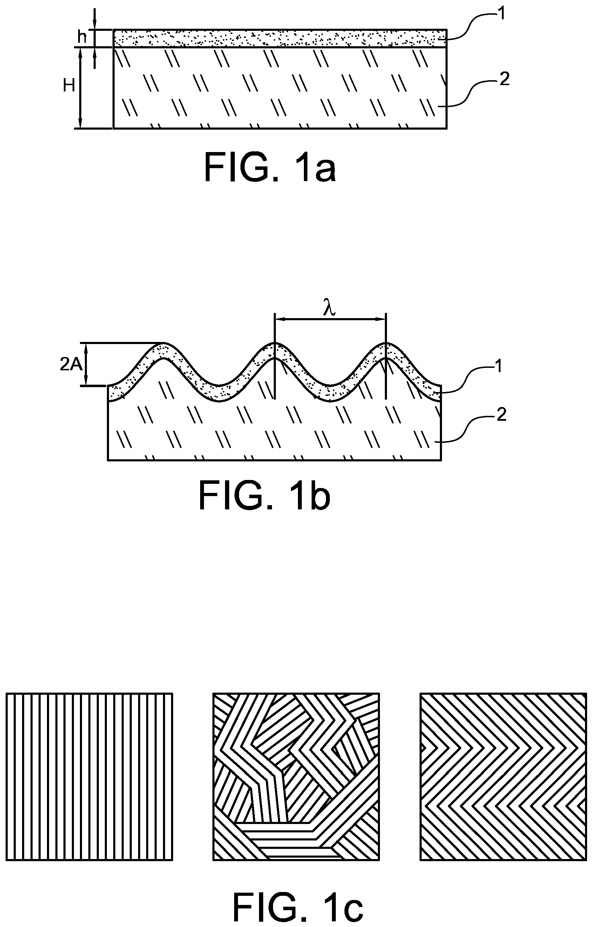

C'est le cas en particulier d'une approche illustrée par les figures la-lc qui repose sur la déformation d'une couche mince élastique 1 d'épaisseur h attachée à un support plus épais 2, d'épaisseur H, désigné par la suite par le terme de fondation. Cette déformation a pour moteur une contrainte qui relativement à la couche élastique correspond à un effort de compression de la fondation sur la couche. Cette contrainte introduit une instabilité du système couche élastique/fondation et conduit à la formation de rides caractérisées, comme représenté sur la figure 1b, par leur longueur d'onde λ et leur amplitude A (correspondant à la moitié de la hauteur crête à crête 2A). Comme représenté sur la figure 1c, les rides sont également caractérisées par leur orientation O qui peut prendre la forme de bandes (à gauche), de labyrinthes (au centre) ou de chevrons (à droite).

La théorie des rides décrit deux modes suivant lesquels le système couche élastique/fondation va gérer cette instabilité.

Lorsqu'à la fois la couche mince 1 et la fondation 2 sont élastiques, le système évolue spontanément pour minimiser son énergie. Dans ce contexte, l'émergence de rides d'une longueur d'onde donnée correspond à un compromis entre l'énergie de flexion du système et l'énergie nécessaire pour déformer la surface de la fondation. La formation des rides est au premier ordre dictée par le rapport des modules élastiques entre la peau et la fondation, leur rapport en épaisseurs et l'intensité de la contrainte à relaxer par le système. Plus la raideur de la fondation est faible, plus la contrainte critique nécessaire à la formation des rides est faible.

Sur le plan pratique, il faut donc des matériaux aux propriétés exceptionnelles (élastique et raideur faible) tels que les élastomères pour observer des rides. Une couche mince fortement contrainte sur une fondation rigide aura en effet tendance à produire une flèche plutôt que des rides.

Il est par ailleurs à noter qu'une fois les rides formées, le système est à l'équilibre. Le retrait de la couche mince provoque dès lors un retour spontané de la fondation élastique à son état initial, à savoir sans rides.

Lorsque la fondation est visqueuse, la formation des rides est provoquée pour des contraintes beaucoup plus faibles et l'énergie du système est principalement dissipée par écoulement visqueux de la fondation. Contrairement au système élastique/élastique, l'amplitude des rides est dans ce cas de figure assujettie à une cinétique qui est gouvernée par le module de relaxation de la fondation visqueuse. L'amplitude des rides est de ce fait limitée, et en pratique incompatible avec les applications visées.

Sur le plan pratique, la compréhension du système élastique/visqueux a permis l'élaboration de stratégies permettant la suppression des rides de faible amplitude. Par exemple en transférant des films contraints sur des fondations ad hoc, il est possible d'inverser le processus de formation des rides. Cela permet par exemple pour des films monocristallins d'autoriser une relaxation par expansion latérale plutôt que par la formation de dislocations.

Il existe pour ce deuxième mode un cas particulier qui correspond à la condition limite d'une fondation liquide. Un film mince contraint déposé sur un liquide forme en effet systématiquement des rides en surface compte tenu du faible module de relaxation du liquide. La manipulation d'un tel système (couche mince sur liquide) est toutefois sensible, ce qui limite à ce jour les applications aux études en laboratoire et/ou à la caractérisation de films minces.

Pour ces différents modes de relaxation, ils existent des solutions analytiques ou semi-analytiques qui permettent de décrire précisément la longueur d'onde et l'amplitude des rides formées. En ce qui concerne l'orientation, de nombreuses études rapportent que des ruptures de contrainte dans le plan sont à l'origine d'orientations privilégiées. Ainsi la création d'un bas-relief et ou bien la définition de motifs permettent d'orienter précisément les rides suivant la distribution du champ de contrainte dans le plan.

Il ressort de ce qui précède que les procédés de structuration de surface par formation de rides sont aujourd'hui essentiellement cantonnés à certains types de polymères, alors que pour les autres matériaux, la faible amplitude des rides obtenues (typiquement de l'ordre de 10 nm, soit inférieure à 20 nm crête à crête) reste incompatible avec les applications visées ou complexe à mettre en œuvre pour une production à grande échelle.

Il est proposé dans le cadre de l'invention d'avoir recours à un procédé de formation de rides qui permet d'étendre la structuration de surface par formation de rides à d'autres matériaux que les polymères, tels que des métaux, des semi-conducteurs, des oxydes, de manière aisément reproductible et avec une amplitude de structuration facilement exploitable, c'est-à-dire supérieure à 30 nm (soit 60 nm crête à crête) et plus typiquement une amplitude supérieure à 100 nm (soit supérieure à 200 nm crête à crête),

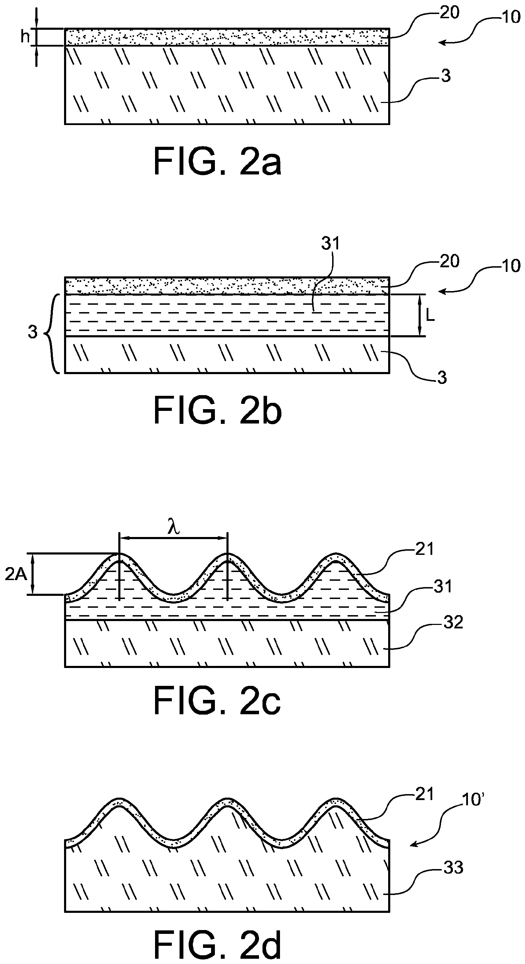

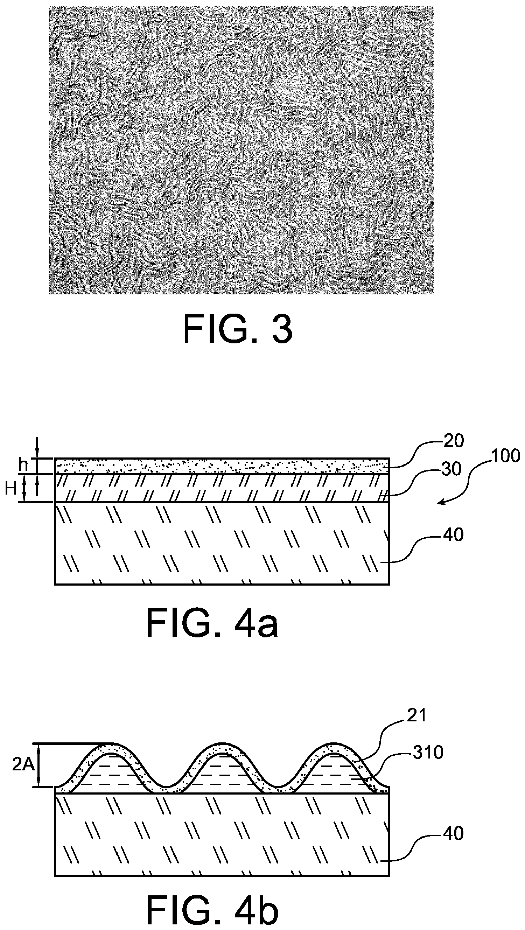

En référence à la figure 2a (ne faisant pas partie de l'invention) et à la figure 4a (qui illustre un cycle fusion/solidification mis en oeuvre dans le procédé selon l'invention), l'invention repose sur un procédé de structuration de surface d'une structure bicouche 10, 100 comprenant initialement une couche contrainte 20 sur une fondation à l'état solide 3, 30. La couche contrainte 20 est plus particulièrement une couche élastique d'épaisseur h tandis que la fondation peut prendre la forme d'un substrat 3 comme représenté sur la figure 2a, ou d'une couche 30 d'épaisseur H formée en surface d'un substrat rigide 40 comme représenté sur la figure 4a.

La couche mince élastique contrainte 20 présente plus particulièrement une contrainte en tension dans au moins une direction du plan de la couche mince, ou bien une contrainte en compression uniquement dans une direction du plan.

La couche mince élastique 20 peut être formée par mise en œuvre d'un dépôt sur la fondation 3, 30, ou encore être formée par mise en œuvre d'une réaction chimique à la surface de la fondation (par exemple une oxydation, nitruration, carburation, etc.). La contrainte de la couche mince élastique est liée notamment au désaccord entre les paramètres de mailles des matériaux constituant la fondation et la couche mince, et peut être ajustée en jouant sur les conditions de formation de la couche mince, par exemple via la température du dépôt qui engendre une contrainte thermique plus ou moins importante selon la différence entre les coefficients de dilatation thermique de la couche mince et de la fondation.

En référence à la figure 2b (ne faisant pas partie de l'invention) et à la figure 4b (qui illustre un cycle fusion/solidification mis en oeuvre dans le procédé selon l'invention), le procédé selon l'invention comprend une étape de fusion d'une partie au moins de la fondation pour l'amener à l'état liquide, ladite partie au moins étant au contact de la couche élastique contrainte.

Ladite partie au moins de la fondation amenée à l'état liquide présente une épaisseur L, et peut correspondre dans un exemple illustratif à une couche supérieure 30 d'une fondation sous la forme d'un substrat 3 au contact de la couche mince élastique (figure 2b) ou encore dans le cadre de l'invention à l'intégralité d'une fondation sous la forme d'une couche 30 d'épaisseur H en surface d'un substrat rigide 40 (figure 4b).

Comme illustré sur la figure 2c (ne faisant pas partie de l'invention) et sur la figure 4b (qui illustre un cycle fusion/solidification mis en oeuvre dans le procédé selon l'invention), ladite partie au moins désormais liquide 31, 310 découple mécaniquement la couche mince élastique contrainte 20 d'une partie solide constituée par la partie solide 32, non fusionnée, du substrat-fondation 3, ou encore constituée par le substrat rigide 40 sous la couche-fondation 30. Durant le temps de fusion, la structure bicouche 10, 100 se positionne dans la condition limite correspondant à une relaxation théorique couche mince élastique / fondation visqueuse avec un temps de relaxation infini. La relaxation de la contrainte de la couche élastique engendre une déformation simultanée de la couche élastique et de ladite partie au moins liquide de la fondation. Le caractère liquide autorise et favorise la formation de rides plutôt qu'une déformation en flexion. Pour obtenir une structuration d'amplitude supérieure à 30 nm, il est nécessaire que l'épaisseur L rendue liquide soit supérieure ou égale à 20 nm, avantageusement supérieure ou égale à 30 nm, et que la durée pendant laquelle cette couche est liquide soit d'au moins 50 ns pour permettre une relaxation maximale de la couche mince 20. Plus l'épaisseur L de la fondation rendue liquide est importante, plus l'amplitude des rides recherchées peut croître. Il existe toutefois une valeur maximale Lmax de l'épaisseur rendue liquide au-delà de laquelle l'amplitude des rides ne peut plus croitre, cette amplitude maximale étant dictée par la théorie des rides dans le régime de croissance homogène et linéaire de l'amplitude. A titre d'exemple illustratif, on choisit, pour une amplitude de ride recherchée supérieure à 75nm, une épaisseur L typiquement de l'ordre de 50 à 100 nm.

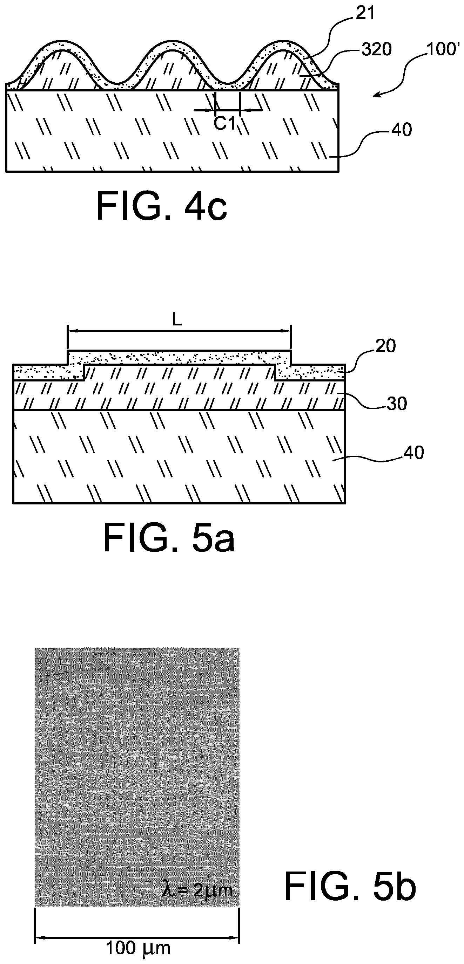

Comme illustré par la figure 2d (ne faisant pas partie de l'invention) et par la figure 4c (qui illustre un cycle fusion/solidification mis en oeuvre dans le procédé selon l'invention), le procédé comprend ensuite une solidification de ladite partie au moins 21, 310 de la fondation pour la ramener à l'état solide, ladite solidification formant une structure solide 10', 100' présentant des rides en surface. Ce retour aux conditions initiales (état solide de la fondation) permet de figer les rides formées.

L'étape de fusion peut être plus particulièrement réalisée par un apport d'énergie sélectif de manière à ce que l'énergie soit majoritairement absorbée par ladite partie au moins de la fondation d'épaisseur L plutôt que par la couche élastique contrainte et que par le substrat rigide sous-jacent 40 le cas échéant, par exemple avec un ratio d'au moins 100/1, de préférence avec un ratio d'au moins 1000/1.

La couche mince présente de préférence une température de fusion supérieure à la température de fusion de la fondation. De la même manière, le substrat rigide 40 soutenant dans l'invention une couche-fondation 30 présente également de préférence une température de fusion supérieure à la température de fusion de la fondation. Alternativement, ou en complément, une couche intermédiaire thermiquement isolante peut être intercalée entre la couche-fondation 30 et le substrat rigide 40 de manière à isoler le substrat rigide 30 des phénomènes thermiques. Ici encore, la couche intermédiaire thermiquement isolante présente de préférence une température de fusion supérieure à la température de fusion de la fondation.

La fondation peut présenter une combinaison de deux matériaux ou plus, de manière à en réduire la température de fusion ou encore d'en améliorer l'absorption de l'apport d'énergie. A titre d'exemple illustratif, un dopage du silicium permet d'en abaisser la température de fusion.

La couche mince peut également présenter une combinaison de deux matériaux ou plus. La combinaison des matériaux peut présenter des propriétés physiques moyennes équivalentes (module d'Young, Poisson, et contrainte) permettant d'ajuster au mieux la structure visée d'après la théorie des rides et/ou peut présenter un comportement moyen vis-à-vis de la source d'énergie de telle sorte que le ratio d'absorption de l'énergie soit au moins de 1/100 idéalement 1/1000 vis-à-vis de la fondation.

La durée de l'étape de fusion est typiquement comprise entre 50ns et 1s, avantageusement entre 50ns et 1ms. On privilégie des durées courtes pour éviter d'élever en température toute la fondation et de trop affecter les propriétés mécaniques de la couche mince. Pour des configurations équivalentes, l'épaisseur de la fondation rendue liquide et la durée à l'état liquide sont les deux paramètres principaux permettant d'ajuster l'amplitude des rides.

La durée de l'étape de refroidissement est également avantageusement contrôlée pour rester inférieure à 1s, avantageusement inférieure à 1ms, et ce afin de préserver les rides pendant le refroidissement. Cette durée peut en particulier être adaptée à la période des rides recherchée. En effet, plus la durée de refroidissement est importante, plus la longueur d'onde des rides est élevée. On peut ainsi freiner le refroidissement, par exemple par un ou plusieurs apports d'énergie pendant cette période, en fonction de la période recherchée.

Suivant la nature des matériaux en jeu, la fusion peut être obtenue en en ayant recours à une source d'énergie laser à une longueur d'onde choisie pour assurer une sélectivité de l'apport d'énergie suivant l'épaisseur et l'absorption des matériaux en jeu, ou encore en ayant recours à une source magnétique d'induction ou une source micro-onde. A titre d'exemple illustratif, on peut utiliser une source laser émettant dans l'ultraviolet, par exemple à une longueur d'onde autour de 300 nm, lorsque la couche mince, par exemple en SiO$_2$, est transparente aux ultra-violets et que la fondation absorbe au contraire cette lumière, par exemple lorsqu'elle constituée de silicium.

Lorsque la fondation est conductrice électriquement (c'est le cas notamment lorsqu'elle est métallique, par exemple en cuivre) et intercalée entre des matériaux électriquement isolant (couche mince d'un côté, couche intermédiaire et/ou substrat rigide 40 de l'autre), la fusion de ladite au moins une partie de la fondation peut être réalisée par un apport d'énergie thermique exploitant l'effet joule. Lorsque la fondation est intercalée entre des matériaux électriquement conducteurs (couche mince d'un côté, couche intermédiaire et/ou substrat rigide 40 de l'autre) et présente une résistivité supérieure à celle desdits matériaux électriquement conducteurs, la fusion de ladite au moins une partie de la fondation peut être réalisée par un apport d'énergie thermique exploitant un échauffement résistif.

La quantité d'énergie nécessaire pour réaliser la fusion de tout ou partie de la fondation peut être prédéterminée en venant détecter le changement de phase de tout ou partie de la fondation d'une structure étalon, par exemple au moyen d'une mesure de réflectivité, de résistivité, de densité, etc.

Les rides créées sont caractérisées par leur longueur d'onde $\lambda$, leur amplitude A et leur orientation O suivant la théorie des rides, et sont principalement liées aux paramètres physiques de la couche mince et de la fondation dans sa phase liquide.

On considère à titre d'exemple illustratif une couche mince en SiO$_2$ (peau) d'une épaisseur h de 50 nm avec une contrainte en tension de 200 MPa. La fondation est en Si amorphe et fusionnée sur une épaisseur L de 150 nm au contact de la couche mince.

Les calculs présentés ici se placent dans le cadre de la théorie des rides pour une structure comprenant un film élastique sur une fondation visqueuse/liquide. La fondation est rendue liquide par fusion de sa phase solide à l'aide d'un apport d'énergie focalisé, typiquement laser (UV 308nm, pulse de 150 ns, énergie de 0,8 J.cm-2). La fondation en silicium absorbe la majorité de l'apport d'énergie fourni, la peau en SiO$_2$ restant transparente à la longueur d'onde de travail.

| Couche mince | | |
|---|---|---|
| Module d'Young | Ep | 80 GPa |
| Poisson | Np | 0.17 |
| Contrainte initiale | Cp | 200 MPa |
| Fondation liquide | | |
| Module d'Young | Ef | 120 GPa |
| Module de relaxation | $\mu$f | 50 MPa |
| Poisson | Np | 0.22 |

## Période des rides

Lorsque les conditions thermodynamiques sont compatibles avec la formation de rides, la période d'oscillation la plus favorable au système est atteinte instantanément. Dans le cadre de l'invention, la période est alors fixée au cours du refroidissement, pendant lequel on considère que la fondation est dans un état visqueux. La période des rides $\lambda$ est définie par la formule ci-dessous, d'après la publication de R. Huang intitulée « Kinetic wrinkling of an elastic film on a viscoelastic substrate », Journal of Mechanics and Physics of Solids, 2004.

$$\lambda = 2\pi\, h \left[ \frac{(1 - \upsilon_f)}{6(1 - \upsilon_p^2)} \frac{E_p}{\mu_f} \right]^{1/3}$$

Le caractère instantané de l'instauration de la période implique que celle-ci va évoluer dans le temps si les paramètres qui la définissent évoluent, notamment $\mu_f$, module de relaxation visqueux de la fondation. $\mu_f$ est défini par la formule suivante :

$$\mu_f = {E_f}/{2(1 + \upsilon_f)}$$

Dans le système dynamique étudié, où la fondation passe de sa phase solide à liquide puis de nouveau solide, la fondation voit son module de relaxation évoluer dramatiquement. D'après Huang 2004, on peut estimer que $\mu_f$ varie sur plus de cinq ordres de grandeur, c'est-à-dire de $50.10^9$ Pa pour sa phase solide à quelques $50.10^4$ Pa pour sa phase visqueuse/liquide. La période $\lambda$ évolue en conséquence pour se figer lors du retour à la phase solide de la fondation autour d'une valeur correspondant à une "valeur moyenne" de $\mu_f$ estimée à $50.10^6$ Pa. Ainsi, dans ce cas, la période d'oscillation calculée est $\lambda = 1.879\mu m$ ce qui correspond à ce qui est observé.

## Amplitude des rides

La croissance de l'amplitude des rides est un phénomène cinétique. Il est d'autant plus rapide que la fondation est dans son état liquide. Ainsi, dans l'exemple étudié où le temps de fusion est de l'ordre 500 ns l'amplitude des oscillations peut atteindre sa valeur maximale décrite dans le cas d'un système peau élastique/fondation liquide.

On peut alors utiliser la formule suivante, d'après la publication de Cerda & Pociavesk, Science, "Stress and Fold Localization in Thin Elastic Membranes", 2008 :

$$A = \frac{\sqrt{2}}{\pi}\, \lambda \sqrt{\frac{\Delta}{W}}\ , \qquad \text{avec} \qquad \Delta = \frac{|\sigma_p|.W}{E_p}$$

représentant la distance de contraction de la peau.

Dans le calcul de la distance $\Delta$, le module d'Young de la peau intervient. Bien que l'on soit dans un cas où l'application de l'énergie est rapide (pulse de 150ns) et que le procédé complet dure moins de $1\mu s$, il est raisonnable de considérer ici que lorsque la fondation est liquide le module d'Young estimée de la peau baisse d'un ordre de grandeur, de $80.10^9$ Pa à $8.10^9$ Pa. On calcule alors une amplitude A de 134 nm soit une hauteur crête à crête de 268 nm.

La figure 3 illustre à ce propos la formation de rides de longueur d'onde d'environ 2 $\mu m$ et d'amplitude crête à crête de 268 nm. Cette amplitude crête à crête correspond ainsi à une amplitude crête à crête théorique des rides qui peut être prédéterminée, et être utilisée pour définir l'épaisseur L de la fondation destinée à être fusionnée en sa phase liquide.

Ainsi, dans le cadre de l'exemple des figures 2a-2d où la fondation prend la forme d'un substrat 3, lorsque l'épaisseur fusionnée est inférieure à une épaisseur prédéterminée correspondant à l'amplitude crête à crête théorique des rides, les rides formées présentent alors une amplitude crête à crête inférieure à l'amplitude crête à crête théorique. Le contrôle de l'épaisseur fusionnée permet ainsi de contrôler l'amplitude des rides formées.

Dans le cadre de l'invention, la fondation prend la forme d'une couche 30 reposant sur un substrat 40, et l'épaisseur H de la couche 30 est inférieure à l'épaisseur prédéterminée correspondant à l'amplitude crête à crête théorique des rides. La formation des rides s'accompagne alors comme représenté sur les figures 4b et 4c d'un contact localisé entre la couche mince 21 et le substrat rigide 40 isolant des régions de la fondation 320. Là où la théorie prédit une amplitude crête à crête théorique d'environ 268 nm, à partir d'une couche mince en $SiO_2$ de 50 nm d'épaisseur et de contrainte initiale en tension d'environ 200 MPa et d'une fondation-couche de 150 nm d'épaisseur, il a été observé une amplitude crête à crête limitée à 230 nm.

Ce contact est transformé en adhésion lorsque les surfaces de la couche mince et du substrat sont lisses, par exemple avec une rugosité de surface inférieure à 5 nm RMS, ou encore un réalisant un apport d'énergie thermique complémentaire de renforcement de l'adhésion, ou encore via la réitération de l'étape de fusion.

## Orientation des rides

S'agissant de l'orientation O des rides, une orientation privilégiée de structuration peut être définie en disposant d'une couche élastique dont la contrainte présente initialement une rupture de continuité dans le plan de la couche, de préférence des ruptures de contrainte dans une seule direction du plan espacées d'une longueur inférieure à 2000 fois l'épaisseur h de la couche. On a représenté sur la figure 5a un bas-relief introduisant de telles ruptures de contrainte, ici espacées de 100 $\mu m$,

avec une couche-fondation 30 présentant une épaisseur de 150 nm au niveau du bas-relief et de 70 nm ailleurs. La figure 5b illustre la formation de rides orientées de manière quasi-parallèle à partir d'une couche mince contrainte 20 en $SiO_2$ de 50 nm d'épaisseur et présentant une contrainte initiale en tension de 100 MPa, d'une couche-fondation 30 en Si présentant le bas-relief de la figure 5a et reposant sur un substrat 40 de Si comportant en surface une couche intermédiaire thermiquement isolante en $SiO_2$.

Dans un mode de réalisation, le procédé peut comprendre une étape initiale de création de motifs en surface de la couche élastique et/ou de la fondation pour induire ladite rupture de continuité de contrainte. Cette création de motifs est par exemple réalisée au moyen d'un trait de laser.

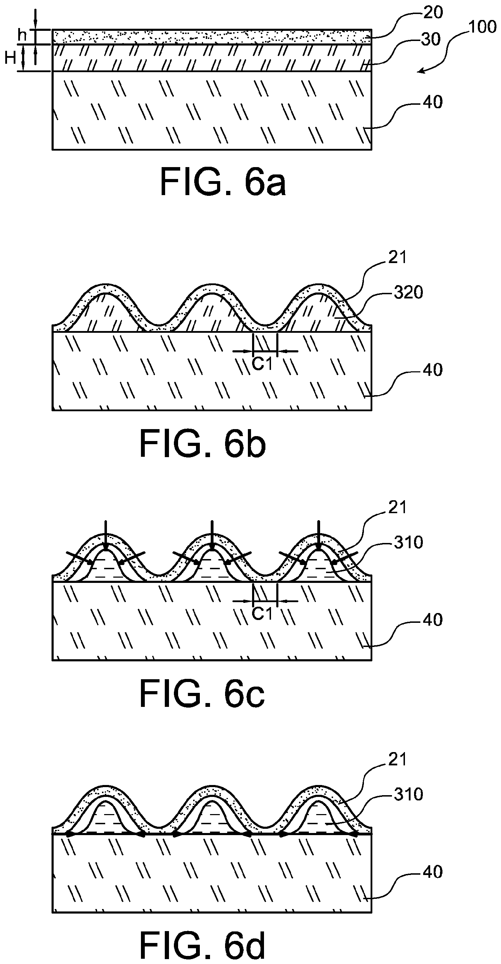

L'invention, qui exploite une fondation qui prend la forme d'une couche 30 reposant sur un substrat 40 dont l'épaisseur L est inférieure à l'épaisseur prédéterminée correspondant à l'amplitude crête à crête théorique des rides, est détaillée ci-après en référence aux figures 6a-6e.

La figure 6a représente la structure initiale 100 constituée du substrat 40, de la fondation 30 et de la couche mince élastique contrainte 20. La figure 6b représente la structure obtenue suite aux étapes de fusion et de solidification décrites précédemment permettant d'aboutir à la formation de rides figées et à un contact localisé de la couche mince ridée 21 avec le substrat 40 isolant des régions de la fondation solide ridée. Une zone de contact localisé couche mince / substrat forme un intervalle séparant deux régions adjacentes de la fondation qui s'étend sur une distance C1.

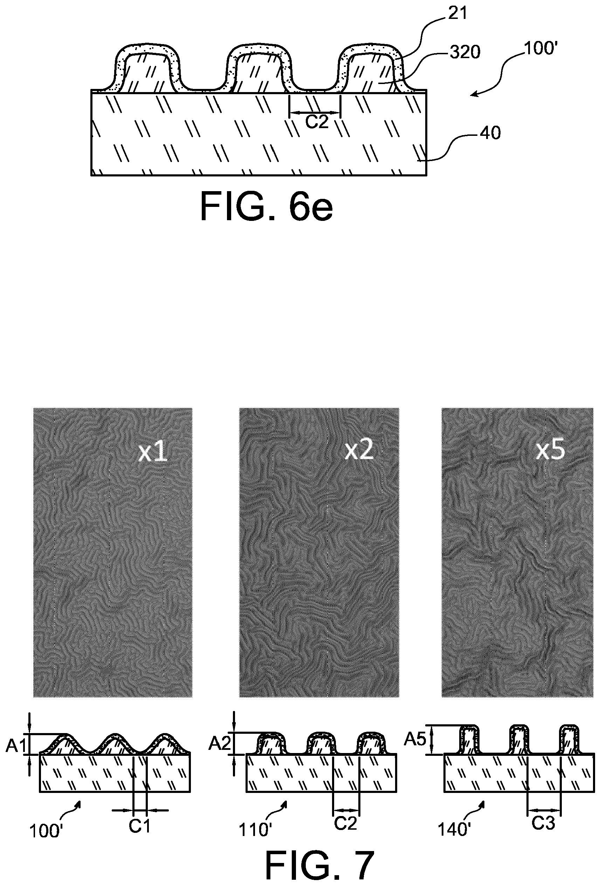

On vient dans le cadre de l'invention réitérer les étapes de fusion et de solidification. En prenant l'exemple d'une fondation en un matériau qui présente la propriété de se contracter volumiquement lors du passage de son état solide à son état liquide (comme c'est le cas par exemple des matériaux suivants : Si, Ga, Ge, Pu, Sb, $\alpha$-$ZrW_2O_8$, $C_2N_2Zn$, $H_2O$), le moindre volume en phase liquide de la fondation 310, illustré sur la figure 6c, s'accompagne en effet d'un contact de la couche mince 21 avec le substrat 40 sur une distance plus importante ce qui favorise l'adhésion comme représenté sur la figure 6d. En variante ou en complément, ce contact sera favorisé si le matériau en phase liquide de la fondation démouille sur le matériau du substrat 40 et de la couche mince élastique contrainte 20 (cela correspond typiquement à un angle de contact supérieur à 50° voire supérieur à 75°). Il en résulte, après solidification, la structure 110' représentée sur la figure 6e pour laquelle l'intervalle C2 entre les régions isolées de la fondation est accentué et l'amplitude des rides est augmentée.

Comme représenté sur la figure 7, il est possible de réitérer à de multiples reprises les étapes de fusion et de solidification, tant que la couche mince résiste à la déformation. Les travaux d'adhésion de la couche mince et du substrat affinent les régions isolées de fondation dans les structures formées 100', 110', 140' (après respectivement 1, 2 et 5 séquences fusion/solidification, de gauche à droite sur la figure 7) qui voient leur amplitude A1, A2, A5 progressivement augmenter tandis que l'intervalle C1, C2, C5 séparant les régions isolées augmente. Les régions isolées présentent l'avantage d'être lisses car issues d'une phase liquide et présentent ainsi moins de défauts par comparaison à des procédés lithographiques suivis de gravure.

La déformation de la peau présentant une limite, lors par exemple d'une contraction volumique obtenue en réitérant l'étape de fusion, le liquide se trouve encore plus confiné et le retour à l'état solide conduit à une élévation trop importante de la pression. Ceci entraîne la rupture de la couche mince dans la zone où le stress est maximal, à savoir au maximum d'amplitude des rides. Cette rupture s'accompagne de l'éruption du liquide en fusion issue de la fondation. Ce liquide peut se déverser le long de la peau et former un objet nanométrique. Si les conditions sont propices, et notamment si le matériau en fusion présente une faible mouillabilité vis-à-vis du matériau de surface de la peau (correspondant typiquement à un angle de goutte supérieure à 80°), une bille nanométrique de matériau peut se former au sommet du cratère. D'autres formes peuvent être obtenues en jouant sur l'environnement d'éruption (par exemple en milieu liquide, sous vide,...).

Le contrôle de l'orientation des rides joue sur la densité et l'homogénéité des objets. Une orientation créant des maxima locaux qui sont appelés à devenir les sites privilégiés de rupture du film peut ainsi être retenue. On peut pour cela avoir recours à une orientation labyrinthique ou à une orientation alvéolaire, ces orientations permettant de confiner la rupture autour d'un point (suivant 3 axes autour d'un maximum local), au contraire d'une orientation rectiligne pour laquelle la rupture de la couche mince pourrait se propager de manière catastrophique le long de la crête.

L'orientation peut notamment être ajustée en plaçant un moule à motif sur la structure bicouche couche mince-fondation. Le moule joue le rôle d'un tampon qui impose l'orientation des rides. Ainsi un moule comprenant un ensemble de pointes cylindriques permet d'obtenir des rides sous la forme d'un ensemble de protrusions arrangées symétriquement selon une orientation alvéolaire type « boîte à œuf ». Une telle orientation « boîte à oeuf » au moyen d'une écriture directe par laser comme par exemple décrit dans l'article Guo, C. F., Nayyar, V., Zhang, Z., Chen, Y., Miao, J., Huang, R. and Liu, Q. (2012), Nanoscale Films: Path-Guided Wrinkling of Nanoscale Metal Films (Adv. Mater. 22/2012). Adv. Mater., 24: 3076. doi: 10.1002/adma.201290130.

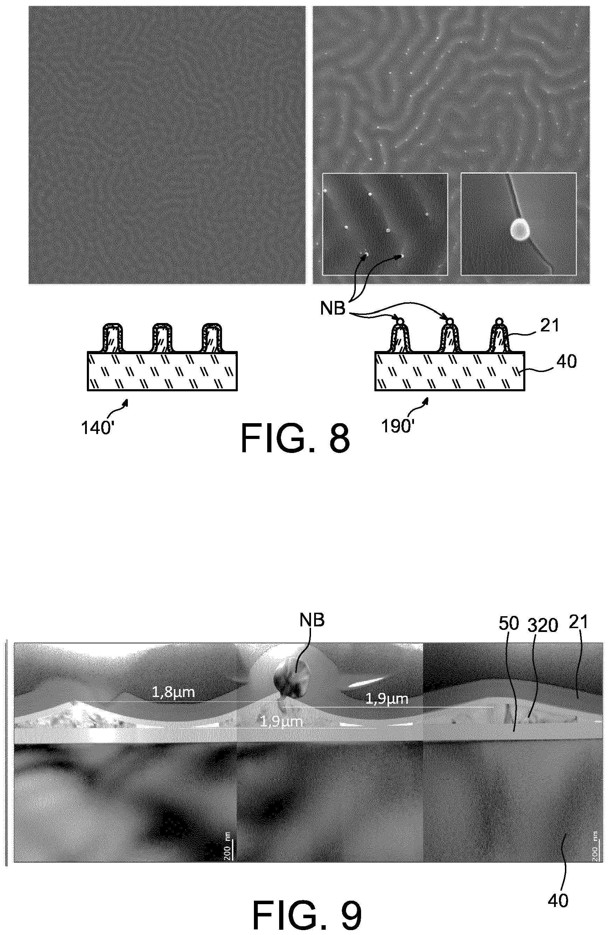

Les figures 8 et 9 illustrent la rupture de la couche mince et l'éruption de billes nanométriques NB, lors d'une dixième réitération de la séquence fusion/solidification dans un exemple de réalisation exploitant une couche mince 21 en $SiO_2$ de 50 nm d'épaisseur et présentant une contrainte initiale en tension de 100 MPa, une couche-fondation 320 en Si présentant une épaisseur initiale de 70 nm et reposant sur un substrat 40 de Si comportant en surface une couche intermédiaire thermiquement isolante 50 en $SiO_2$ de 150 nm d'épaisseur.

Les billes nanométriques NB peuvent être collectées par retrait de la couche mince ridée 21 et application d'ultra-son ou d'un jet liquide. Cette collecte peut être facilitée lorsqu'un traitement de surface a été appliqué à la couche mince pour qu'elle présente peu d'affinité avec les billes.

Par ailleurs, la fondation peut être réalisée en un alliage (par exemple un alliage majoritaire de Si du type Au-Si, Ge-Si, ou encore Si et un métal à température de fusion inférieure à 1000°C) ce qui permet de contrôler la composition de la matière éruptive et d'obtenir des nanobilles multi matériaux présentant soit une ségrégation (par exemple une nanobille de Si recouverte d'une couche d'or, pouvant par exemple être utilisé en tant que germe de croissance cristalline de nanofils selon la méthode VLS - « vapor-liquid-solid »), soit un alliage particulier suivant le diagramme binaire et le chemin de refroidissement emprunté.

## Revendications

1. Procédé de fabrication d'un objet nanométrique à partir d'une structure (100) comprenant une couche élastique contrainte (20) sur une fondation (30) à l'état solide présente en surface d'un substrat rigide (40), le procédé comportant la mise en œuvre des étapes de :

   - fusion de la fondation (31, 310) pour l'amener à l'état liquide pendant une durée supérieure ou égale à 50 ns, l'épaisseur (H) de la fondation étant d'au moins 20 nm et inférieure à une épaisseur prédéterminée correspondant à une amplitude crête à crête théorique de rides, ladite fusion résultant en une relaxation de contrainte de la couche élastique qui engendre une déformation simultanée, par formation de rides, de la couche élastique (21) et de la fondation (31, 310), la formation des rides s'accompagnant d'un contact localisé entre la couche élastique (21) et le substrat rigide (40) isolant des régions de la fondation (320) ;
   - solidification de la fondation pour la ramener à l'état solide (33, 320), ladite solidification formant une structure solide (10', 100') présentant des rides en surface ;

   le procédé étant **caractérisé en ce que** les étapes de fusion et de solidification sont réitérées pour augmenter l'intervalle (C1, C2, C5) entre les régions isolées de la fondation (320) jusqu'à atteindre la limite de rupture de la couche élastique (21), la rupture de la couche élastique s'accompagnant d'une éruption du liquide en fusion issu de la fondation qui va former l'objet nanométrique.

2. Procédé selon la revendication 1, dans lequel la fusion est réalisée au moyen d'un apport d'énergie sélectif selon lequel l'énergie est absorbée par la fondation plutôt que par la couche élastique contrainte avec un ratio de 100/1, de préférence avec un ratio de 1000/1.

3. Procédé selon l'une des revendications 1 et 2, dans lequel la durée de chacune des étapes de fusion et de solidification est inférieure à 1 seconde, de préférence inférieure à 1 microseconde.

4. Procédé selon l'une des revendications 1 à 3, dans lequel une couche thermiquement isolante (50) est intercalée entre la fondation et le substrat rigide.

5. Procédé selon l'une des revendications 1 à 4, dans lequel, la fondation (30) étant conductrice électriquement et intercalée entre des matériaux électriquement isolant, la fusion de ladite au moins une partie de la fondation est réalisée par un apport d'énergie thermique exploitant l'effet joule.

6. Procédé selon l'une des revendications 1 à 4, dans lequel, la fondation (30) étant intercalée entre des matériaux électriquement conducteurs et présentant une résistivité supérieure à celle desdits matériaux électriquement conducteurs, la fusion de ladite au moins une partie de la fondation est réalisée par un apport d'énergie thermique exploitant un échauffement résistif.

7. Procédé selon l'une des revendications 1 à 6 dans lequel la rupture de la couche élastique (21) s'accompagne d'une éruption de billes nanométriques (NB), comprenant en outre une étape de collecte des billes nanométriques (NB).

8. Procédé selon l'une des revendications 1 à 7, dans lequel la couche élastique dispose initialement d'une contrainte présentant une rupture de continuité dans le plan de la couche.

9. Procédé selon la revendication 8, comprenant une étape de création de motifs en surface de la couche élastique et/ou de la fondation pour induire ladite rupture de continuité.

## Patentansprüche

1. Verfahren zur Herstellung eines nanometrischen Objekts aus einer Struktur (100), die eine beanspruchte elastische Schicht (20) auf einem Untergrund (30) im festen Zustand enthält, der an der Oberfläche eines starren Substrats (40) vorhanden ist, wobei das Verfahren das Ausführen der nachstehenden Schritte umfasst:

- Schmelzen des Untergrunds (31, 310), um ihn für eine Zeitdauer von mehr als oder gleich 50 ns in den flüssigen Zustand zu bringen, wobei die Dicke (H) des Untergrunds mindestens 20 nm und weniger als eine vorbestimmte Dicke beträgt, die einer theoretischen Spitze-Spitze-Amplitude von Falten entspricht, wobei das Schmelzen zu einer Spannungsrelaxation der elastischen Schicht führt, die eine gleichzeitige Verformung der elastischen Schicht (21) und des Untergrunds (31, 310) durch Faltenbildung bewirkt, wobei die Faltenbildung mit einem bereichsweisen Kontakt zwischen der elastischen Schicht (21) und dem starren Substrat (40) einhergeht, welcher Bereiche des Untergrunds (320) trennt;
- Verfestigen des Untergrunds, um ihn in den festen Zustand (33, 320) zurückzubringen, wobei das Verfestigen eine feste Struktur (10', 100') mit Oberflächenfalten bildet;

wobei das Verfahren **dadurch gekennzeichnet ist, dass**
die Schritte des Schmelzens und des Verfestigens wiederholt werden, um den Spalt (C1, C2, C5) zwischen den getrennten Bereichen des Untergrunds (320) zu vergrößern, bis die Bruchgrenze der elastischen Schicht (21) erreicht ist, wobei der Bruch der elastischen Schicht mit einer Eruption der Flüssigschmelze aus dem Untergrund einhergeht, aus welcher das nanometrische Objekt gebildet wird.

2.  Verfahren nach Anspruch 1,
    wobei das Schmelzen mittels selektiver Energiezufuhr durchgeführt wird, wobei die Energie vielmehr von dem Untergrund und weniger von der beanspruchten elastischen Schicht in einem Verhältnis von 100:1, vorzugsweise in einem Verhältnis von 1000:1, absorbiert wird.

3.  Verfahren nach einem der Ansprüche 1 und 2,
    wobei die Dauer jeder der Schritte des Schmelzens und des Verfestigens weniger als 1 Sekunde, vorzugsweise weniger als 1 Mikrosekunde, beträgt.

4.  Verfahren nach einem der Ansprüche 1 bis 3,
    wobei eine wärmeisolierende Schicht (50) zwischen dem Untergrund und dem starren Substrat eingefügt ist.

5.  Verfahren nach einem der Ansprüche 1 bis 4,
    wobei bei einem elektrisch leitenden und zwischen elektrisch isolierenden Materialien eingefügten Untergrund (30) das Schmelzen des zumindest einen Teils des Untergrunds durch Zufuhr von Wärmeenergie unter Ausnutzung des Joule-Effekts erfolgt.

6.  Verfahren nach einem der Ansprüche 1 bis 4,
    wobei bei einem Untergrund (30), der zwischen elektrisch leitenden Materialien eingefügt ist und einen spezifischen Widerstand aufweist, der größer ist als der der elektrisch leitenden Materialien, das Schmelzen des zumindest einen Teils des Untergrunds durch Zufuhr von Wärmeenergie unter Ausnutzung einer Widerstandserwärmung erfolgt.

7.  Verfahren nach einem der Ansprüche 1 bis 6,
    wobei das Brechen der elastischen Schicht (21) mit einer Eruption von Nanokügelchen (NB) einhergeht, ferner umfassend einen Schritt des Auffangens der Nanokügelchen (NB).

8.  Verfahren nach einem der Ansprüche 1 bis 7,
    wobei die elastische Schicht anfänglich eine Spannung aufweist, die einen Kontinuitätsbruch in der Ebene der Schicht zeigt.

9.  Verfahren nach Anspruch 8, umfassend einen Schritt des Erzeugens von Oberflächenmustern auf der elastischen Schicht und/oder dem Untergrund, um den Kontinuitätsbruch herbeizuführen.

**Claims**

1.  A method for manufacturing a nanoscale object from a structure (100) comprising a strained elastic layer (20) on a foundation (30) in the solid state present at the surface of a rigid substrate (40), the method comprising the implementation of the steps of:

    - melting the foundation (31, 310) to bring it to liquid state for a duration higher than or equal to 50 ns, the thickness (H) of the foundation being at least 20nm and lower than a predetermined thickness corresponding to a theoretical peak-to-peak amplitude of wrinkles, said melting resulting in a stress relaxation of the elastic layer which generates a simultaneous deformation, by formation of wrinkles, of the elastic layer (21) and of the foundation (31, 310), the formation of the wrinkles being accompanied by a localized contact between the elastic layer (21) and the rigid substrate (40) separating regions of the foundation (320) ;
    - solidifying the foundation to bring it back to solid state (33, 320), said solidification forming a solid structure (10', 100') having wrinkles at the surface;

    the method being **characterized in that** the melting and solidification steps are reiterated to increase the interval (C1, C2, C5) between the separated regions of the foundation (320) until it reaches the yield point of the elastic layer (21), the rupture of the elastic layer (21) being accompanied by an eruption of the liquid from the foundation which is to form the nanoscale object.

2. The method according to claim 1, wherein the melting is made by means of a selective energy supply according to which the energy is absorbed by the foundation rather than by the strained elastic layer with a ratio of 100/1, preferably with a ratio of 1000/1.

3. The method according to one of claims 1 and 2, wherein the duration of each of the melting and solidification steps is lower than 1 second, preferably lower than 1 microsecond.

4. The method according to one of claims 1 to 3, wherein a thermally insulating layer (50) is inserted between the foundation and the rigid substrate.

5. The method according to one of claims 1 to 4, wherein, the foundation (30) being electrically conducting and inserted between electrically insulating materials, the melting of said at least part of the foundation is made by a thermal energy supply making use of the Joule effect.

6. The method according to one of claims 1 to 4, wherein, the foundation (30) being inserted between electrically conducting materials and having a resistivity higher than that of said electrically conducting materials, the melting of said at least part of the foundation is made by a thermal energy supply making use of a resistive heating.

7. The method according to one of claims 1 to 6, wherein the rupture of the elastic layer (21) is accompanied by an eruption of nanoscale balls (NB), further comprising a step of collecting the nanoscale balls (NB).

8. The method according to one of claims 1 to 7, wherein the elastic layer initially has a stress having a discontinuity in the plane of the layer.

9. The method according to claim 8, comprising a step of creating patterns at the surface of the elastic layer and/or of the foundation to induce said discontinuity.

FIG. 1a

FIG. 1b

FIG. 1c

FIG. 2a

FIG. 2b

FIG. 2c

FIG. 2d

FIG. 3

FIG. 4a

FIG. 4b

FIG. 4c

FIG. 5a

FIG. 5b

FIG. 6a

FIG. 6b

FIG. 6c

FIG. 6d

FIG. 6e

FIG. 7

FIG. 8

FIG. 9

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **G.K. GIUST ; T.W. SIGMON.** New ripple patterns observed in excimer-laser irradiated SiO2/polycrystalline silicon/SiO2 structures. *Appl. Phys. Lett.,* 1997, vol. 70, 3552
- **URYI P. VOLKOV.** Microscopy of Si and Ge nanospherical particles. *Proceedings of the SPIE,* 04 Juillet 2004, 21-25
- **R. HUANG.** Kinetic wrinkling of an elastic film on a viscoelastic substrate. *Journal of Mechanics and Physics of Solids,* 2004

- **CERDA ; POCIAVESK.** Stress and Fold Localization in Thin Elastic Membranes. *Science,* 2008
- **GUO, C. F. ; NAYYAR, V. ; ZHANG, Z. ; CHEN, Y. ; MIAO, J. ; HUANG, R. ; LIU, Q.** Nanoscale Films: Path-Guided Wrinkling of Nanoscale Metal Films. *Adv. Mater. 22/2012). Adv. Mater.,* 2012, vol. 24, 3076